# EUROPEAN PATENT APPLICATION

(11) **EP 4 618 236 A1**
(43) Date of publication of application: **17.09.2025**
(21) Application number: 23906480.1
(22) Date of filing: 31.10.2023
(51) Int. Cl.: H01M 10/48, G01R 31/392, H02J 7/00

(54) **COMPOSITE BATTERY SYSTEM**

(30) Priority: 20.12.2022 WO PCT/JP2022/046832
(71) Applicant: Connexx Systems Corporation, Kyoto 619-0294 (JP)
(72) Inventor: TSUKAMOTO Hisashi, Soraku-gun, Kyoto 619-0294 (JP)
(74) Representative: Becker, Eberhard
(86) International application number: PCT/JP2023/039332
(87) International publication number: WO 2024/135108

(57) **Abstract**

Provided is a composite battery system that makes it possible to simplify the configuration thereof while ensuring the designed electric power storage capacity, and to identify a degraded lithium-ion battery and replace only the identified battery. Each of a plurality of composite units 12 that constitute the composite battery system 10 is provided with a plurality of main battery portions 20 and an auxiliary battery portion 30, the composite units 12 being connected to each other in series. Each of the plurality of main battery portions 20 is configured from a lithium-ion battery 22 and a switch 24, the plurality of main battery portions being connected to each other in parallel. The auxiliary battery portion 30 is configured from a lead storage battery 32 and is connected in parallel to the plurality of main battery portions 20. When the lithium-ion batteries 20 that constitute the plurality of main battery portions 20 are configured from conducting batteries and non-conducting batteries, an EMS 16 compares the total value of the capacity of the conducting batteries and the total value of the capacity of the non-conducting batteries, and switches on the switches 24 of the non-conducting batteries if the voltage of the batteries that have the smaller total value of capacity is higher than the voltage of the batteries that have the larger total value of capacity.

## Description

### Technical Field

The present invention relates to a composite battery system using multiple composite units configured with lead-acid batteries and lithium-ion batteries and connected in series with each other.

### Background Technology

Conventionally, it is known that a composite battery with lead-acid batteries and lithium-ion batteries connected in parallel can increase the stored energy per weight and especially improve low-temperature power performance. Various technologies have been disclosed to enhance the safety of composite batteries. Patent Document 1 discloses a composite battery system that is capable of maintaining safety even if the voltage sensor, current sensor, temperature sensor, etc. provided for the lithium-ion batteries fail. On the other hand, regarding the safety of secondary batteries constituting an electric power storage device during deterioration, Patent Document 2 discloses a battery assembly in which a diagnostic means diagnoses the degree of deterioration or failure of each battery unit based on the voltage of a cell group or each cell, and Patent Document 3 discloses a charging and discharging control device that measures the current value of each single battery during charging and disconnects an abnormal single battery detected based on this measurement value from parallel connection by controlling a switching element.

### Related Art Documents

### Patent Documents

Patent Document 1: Japanese Patent Application Laid-Open No. 2017-208983
Patent Document 2: Japanese Patent No. 5564561
Patent Document 3: Japanese Patent Application Laid-Open No. 2013-038884

### SUMMARY OF INVENTION

### Problems to be Solved by the Invention

In Patent Document 1, when at least one of overcharging and overdischarging is detected by a voltage detector provided for detecting the voltage value of each composite battery, the composite battery system operates a unit disconnector to electrically disconnect multiple composite batteries included in the same composite battery unit as the composite battery equipped with the voltage detector, even if the voltage sensor, current sensor, temperature sensor, etc. provided for the lithium-ion batteries fail. However, Patent Document 1 has a problem that it does not consider identifying the deteriorated lithium-ion battery and replacing only the identified battery.

In addition, Patent Document 2 has a problem that the circuit configuration becomes complicated with an increased number of switches for it diagnoses the degree of deterioration of each battery unit based on the ratio of the voltage measurement value when the second current control element is turned off to the voltage measurement value when the second current control element is turned on, while the first current control element is turned off. Patent Document 2 also has a problem that it does not consider identifying the deteriorated battery after diagnosing the degree of deterioration of each battery unit, and replacing only the identified battery. Moreover, Patent Document 3 has a problem that the circuit configuration becomes complicated with an increased number of switches for it connects all five single batteries to the charging and discharging path through a current measurement portion during charging, and connects the batteries to the charging and discharging path without going through the current measurement portion during discharging.

The present invention has been made in view of such conventional problems, and aims to provide a composite battery system that is capable of simplifying the configuration while ensuring the electric power storage capacity according to specifications, and identifying a deteriorated lithium-ion battery and replacing only the identified battery.

In addition to the above, the present invention further aims to provide a composite battery system that is capable of maintaining safety at a level equal to or higher than conventional systems, effectively utilizing resources, expanding applications, and enhancing expandability.

### Means for Solving the Problems

The inventors of the present invention, after conducting extensive research to achieve the above, have found that by configuring multiple main battery portions with main battery portions of a basic connection number set based on specifications and main battery portions of a surplus connection number set as a surplus portion with respect to the basic connection number, and by calculating the connection number of deteriorated batteries among the multiple main battery portions and sending a signal requesting replacement of deteriorated batteries to an external device when the connection number of deteriorated batteries becomes equal to the surplus connection number, it is possible to replace only deteriorated lithium-ion batteries while ensuring the electric power storage capacity according to specifications.

Furthermore, the inventors of the present invention have found that by defining deterioration as when the measurement value of current of each lithium-ion battery in the multiple main battery portions deviates from a predetermined range, as a result of the lithium-ion battery deteriorating due to repeated charging and discharging of the multiple main battery portions, it is possible to simplify the configuration and identify deteriorated lithium-ion batteries, thus arriving at the present invention.

That is, the first embodiment of the present invention provides a composite battery system, including: a plurality of composite units each including a plurality of main battery portions each of which includes a lithium-ion battery and a switch that electrically connects or disconnects the lithium-ion battery and which are connected in parallel with each other, and an auxiliary battery portion which includes a lead-acid battery and is connected in parallel with the plurality of main battery portions, the plurality of composite units being connected in series with each other; an HV portion directly or indirectly acquiring measurement values of voltage, current, and temperature during charging and discharging of the lithium-ion battery; an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and a housing storing the plurality of composite units and the HV portion, in which the EMS recognizes the lithium-ion battery as the deteriorated battery in a case where the measurement value of current during at least one of charging and discharging deviates from a predetermined range, and in which in at least one composite unit of the plurality of composite units, in a case where the lithium-ion batteries constituting the plurality of main battery portions include one or more conducting batteries connected to the switches in an on state and one or more non-conducting batteries connected to the switches in an off state, the EMS compares a total value of capacities of the conducting batteries with a total value of capacities of the non-conducting batteries, and turns on the switches in the off state of the non-conducting batteries when a voltage of batteries with a smaller total value of capacities is higher than a voltage of batteries with a larger total value of capacities.

Further, the second embodiment of the present invention provides a composite battery system, including: a plurality of composite units each including a plurality of main battery portions each of which includes a lithium-ion battery and a switch that electrically connects or disconnects the lithium-ion battery and which are connected in parallel with each other, and an auxiliary battery portion which includes a lead-acid battery and is connected in parallel with the plurality of main battery portions, the plurality of composite units being connected in series with each other; an HV portion directly or indirectly acquiring measurement values of voltage, current, and temperature during charging and discharging of the lithium-ion battery; an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and a housing storing the plurality of composite units and the HV portion, in which the plurality of main battery portions include main battery portions of a basic connection number set based on specifications for each of the plurality of composite units, and main battery portions of a surplus connection number set as a surplus portion with respect to the basic connection number, in which for each of the plurality of composite units, the basic connection number is 2 or more, and the surplus connection number is 1 or more, and in which the EMS recognizes a lithium-ion battery as a deteriorated battery in a case where the measurement value of current during both charging and discharging deviates from a predetermined range, and calculates each average value of measurement values obtained by simultaneously measuring current in each state of charging and discharging of each lithium-ion battery constituting each of the plurality of main battery portions.

Further, the third embodiment of the present invention provides a composite battery system, including: a plurality of composite units each including a plurality of main battery portions each of which includes a lithium-ion battery and a switch that electrically connects or disconnects the lithium-ion battery and which are connected in parallel with each other, and an auxiliary battery portion which includes a lead-acid battery and is connected in parallel with the plurality of main battery portions, the plurality of composite units being connected in series with each other; an HV portion directly or indirectly acquiring measurement values of voltage, current, and temperature during charging and discharging of the lithium-ion battery; an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and a housing storing the plurality of composite units and the HV portion, in which the plurality of main battery portions include main battery portions of a basic connection number set based on specifications for each of the plurality of composite units, and main battery portions of a surplus connection number set as a surplus portion with respect to the basic connection number, in which for each of the plurality of composite units, the basic connection number is 4 or more, and the surplus connection number is 1 or more, and in which the EMS recognizes a lithium-ion battery as a deteriorated battery in a case where the measurement value of current during at least one of charging and discharging deviates from a predetermined range, and in a case where there is a lithium-ion battery that the EMS recognizes as the deteriorated battery among the plurality of main battery portions, the EMS excludes the measurement value of the lithium-ion battery from measurement values obtained by simultaneously measuring current in each state of charging and discharging of each lithium-ion battery constituting each of the plurality of main battery portions, further excludes one measurement value with a maximum magnitude and one measurement value with a minimum magnitude from remaining measurement values, and calculates each average value of remaining measurement values.

Furthermore, in the second and third embodiments of the present invention, preferably, the EMS calculates a connection number of the deteriorated battery among the plurality of main battery portions for each of the plurality of composite units, and in a case where the connection number of the deteriorated battery becomes equal to the surplus connection number, the EMS sends a signal requesting replacement of the deteriorated battery to the external device.

Furthermore, in the first to third embodiments of the present invention, preferably, the auxiliary battery portion further includes: a current meter that measures current flowing through the lead-acid battery; an auxiliary switch that electrically connects or disconnects the lead-acid battery; and an auxiliary BMS, in which the auxiliary BMS turns on/off the auxiliary switch based on the measurement value of current flowing through the lead-acid battery, and notifies the external device of the measurement value of current flowing through the lead-acid battery via the HV portion and the EMS.

Furthermore, in the first to third embodiments of the present invention, preferably, the auxiliary battery portion further includes a fuse that interrupts current flowing through the lead-acid battery in a case where overcurrent flows through the lead-acid battery.

Preferably, each of the plurality of main battery portions includes a BMS, and the BMS measures the voltage, current, and temperature of the lithium-ion battery, calculates SOC and SOH based on the voltage, current, and temperature, and notifies the external device of measurement values of the voltage, current, and temperature and calculated values of the SOC and SOH via the HV portion and the EMS.

Preferably, the HV portion measures the voltage, current, and temperature of the lithium-ion battery, calculates SOC and SOH based on the voltage, current, and temperature, and notifies the external device of measurement values of the voltage, current, and temperature and calculated values of the SOC and SOH via the EMS.

Furthermore, in the first to third embodiments of the present invention, preferably, the composite battery system further includes: a thermometer that measures a temperature inside the housing; and a heating and cooling device that changes the temperature inside the housing, in which the EMS turns on/off at least one of the heating and cooling device and the switch based on a temperature of the lithium-ion battery and a measurement value of the thermometer, and notifies the external device of the temperature of the lithium-ion battery and the measurement value of the thermometer.

Furthermore, preferably, the composite battery system further includes a fire extinguisher that automatically detects and extinguishes flames generated inside the housing, in which the EMS notifies the external device of operation of the fire extinguisher in a case where the fire extinguisher operates.

Furthermore, preferably, the composite battery system further includes: a hydrogen gas sensor that measures a concentration of hydrogen gas inside the housing; and a fan that ventilates air inside the housing, in which the auxiliary battery portion further includes an auxiliary switch that electrically connects or disconnects the lead-acid battery, and in which the EMS turns on/off at least one of the fan and the auxiliary switch based on a measurement value of the concentration of hydrogen gas, and notifies the external device of the measurement value of the concentration of hydrogen gas.

Furthermore, in the first to third embodiments of the present invention, preferably, the composite battery system further includes: an organic gas sensor that measures a concentration of organic gas inside the housing; and a fan that ventilates air inside the housing, in which the EMS turns on/off at least one of the fan and the switch based on a measurement value of the concentration of organic gas, and notifies the external device of the measurement value of the concentration of organic gas.

Furthermore, preferably, the composite battery system further includes a PCS that is disposed inside or outside the housing, converts discharge power from the lithium-ion battery and the lead-acid battery to the external device from direct current to alternating current, and converts charging power from the external device to the lithium-ion battery and the lead-acid battery from alternating current to direct current.

Preferably, the EMS turns on/off the switch based on the measurement value of voltage, and notifies the external device of the measurement value of voltage, and the EMS receives a notification from the HV portions stored respectively in a plurality of the housings.

The predetermined range is preferably 70% to 130% for both an average value of measurement values during charging and an average value of measurement values during discharging.

### Effects of the Invention

According to the present invention, it is possible to simplify the configuration while ensuring the electric power storage capacity according to specifications, and to identify a deteriorated lithium-ion battery and replace only the identified battery.

Furthermore, in addition to the above effects, according to the present invention, it is possible to maintain safety at a level equal to or higher than conventional systems, effectively utilize resources, expand applications, and enhance expandability.

### BRIEF DESCRIPTION OF THE DRAWINGS

[FIG. 1] is a block diagram showing the composite battery system of the present invention.
[FIG. 2] is a block diagram showing a modification example of the auxiliary battery portion constituting the composite battery system of FIG. 1.
[FIG. 3] is a block diagram showing a specific module configuration of the main battery portion constituting the composite battery system of FIG. 1.
[FIG. 4] is a block diagram showing another specific module configuration of the main battery portion of FIG. 3.
[FIG. 5] is a block diagram showing a specific module configuration of the auxiliary battery portion constituting the composite battery system of FIG. 1.
[FIG. 6] is a block diagram showing a specific module configuration of the modification example of the auxiliary battery portion of FIG. 2.

### DESCRIPTION OF THE EMBODIMENTS

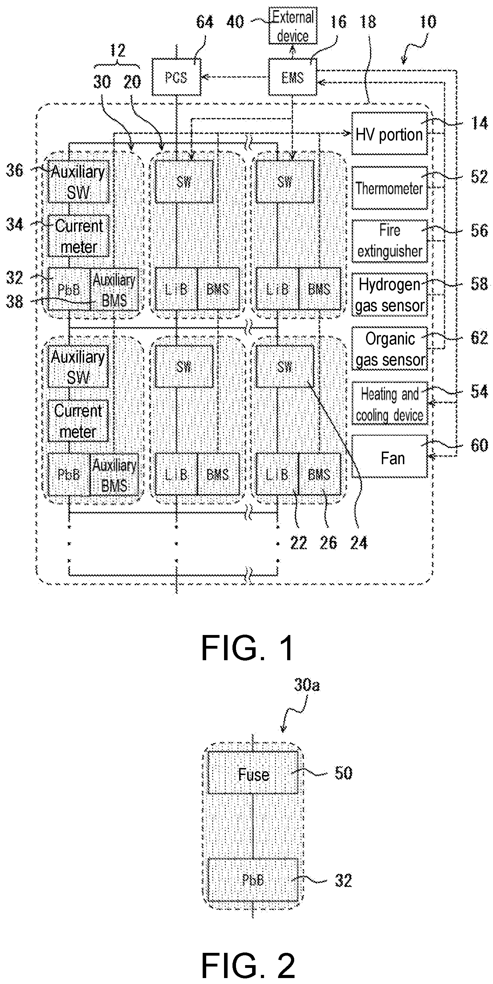

Hereinafter, the composite battery system of the present invention will be described in detail based on preferred embodiments shown in the attached figures. FIG. 1 is a block diagram showing the composite battery system of the present invention.

The composite battery system 10 of the first to third embodiments of the present invention includes multiple composite units 12, an HV portion 14, an EMS 16, and a housing 18. The multiple composite units 12 each include multiple main battery portions 20 and an auxiliary battery portion 30, and are connected in series with each other. The multiple main battery portions 20 are each configured with a lithium-ion battery 22 and a switch 24, and are connected in parallel with each other. The switch 24 electrically connects or disconnects the lithium-ion battery 22. The auxiliary battery portion 30 is configured with a lead-acid battery 32, and is connected in parallel with the multiple main battery portions 20.

The HV portion 14 directly or indirectly acquires measurement values of voltage, current, and temperature during charging and discharging of the lithium-ion battery 22. The EMS 16, in a case of recognizing a lithium-ion battery 22 that has deteriorated due to repeated charging and discharging of the multiple main battery portions 20 as a deteriorated battery, turns off the switch 24 connected to the deteriorated battery and notifies an external device 40 of information identifying the deteriorated battery. The housing 18 stores the multiple composite units 12 and the HV portion 14.

In other words, the entirety of the multiple composite units 12 is configured by connecting M main battery portions 20 in parallel and N in series in a matrix arrangement, where each main battery portion 20 is configured by connecting the lithium-ion battery 22 and the switch 24 in series with each other, and then connecting the auxiliary battery portion 30 configured with the lead-acid battery 32 in parallel to each of the N main battery portions 20 connected in series. In addition, the deteriorated battery refers to a lithium-ion battery 22 whose internal resistance during charging and discharging gradually increases due to repeated charging and discharging, or suddenly decreases due to internal short circuit, and the measurement value of current deviates from a predetermined range. Further, the information identifying the deteriorated battery includes the manufacturing number of the lithium-ion battery 22 whose measurement value of current deviates from a predetermined range, a combination of the ordinal number of the parallel connection (the number out of M) and the ordinal number of the series connection (the number out of N) in the matrix connection state, and so on. The HV portion 14 and the EMS 16 are configured with electrical circuits, and include a CPU as needed.

Next, a method for turning on the switch of a new lithium-ion battery after replacing a deteriorated battery with the new lithium-ion battery, which is applied to the composite battery system 10 of the first embodiment of the present invention, will be described.

The EMS 16 recognizes a lithium-ion battery as a deteriorated battery in a case where the measurement value of current during at least one of charging and discharging deviates from a predetermined range. In at least one composite unit 12 of the multiple composite units 12, it can be assumed that the lithium-ion batteries 22 constituting the multiple main battery portions 20 are configured with one or more conducting batteries and the remaining one or more non-conducting batteries, where the conducting batteries are connected to the switches 24 in the on state, and the non-conducting batteries are connected to the switches 24 in the off state. In that case, the EMS 16 compares the total value of capacities of the conducting batteries with the total value of capacities of the non-conducting batteries, and turns on the switches 24 in the off state of the non-conducting batteries when the voltage of the batteries with the smaller total value of capacities is higher than the voltage of the batteries with the larger total value of capacities. The predetermined range may be 70% to 130% for both the average value of measurement values during charging and the average value of measurement values during discharging.

For example, in a case where the total value of capacities of the conducting batteries is smaller, when the voltage of the conducting batteries is higher than the voltage of the non-conducting batteries, that is, during the period from when both voltages become equal until fully charged during charging of the conducting batteries, or during the period from fully charged until both voltages become equal during discharging of the conducting batteries, the switches 24 in the off state of the non-conducting batteries are turned on. As a result, the inrush current at the time of turning on the switches 24 flows from the conducting batteries with the smaller total value of capacities to the non-conducting batteries with the larger total value of capacities, so the C-rate at the inflow side of the inrush current becomes smaller compared to the case where the current flows in the reverse direction.

Conversely, in a case where the total value of capacities of the non-conducting batteries is smaller, when the voltage of the non-conducting batteries is higher than the voltage of the conducting batteries, that is, during the period from complete discharge until both voltages become equal during charging of the conducting batteries, or during the period from when both voltages become equal until complete discharge during discharging of the conducting batteries, the switches 24 in the off state of the non-conducting batteries are turned on. As a result, the inrush current at the time of turning on the switches 24 flows from the non-conducting batteries with the smaller total value of capacities to the conducting batteries with the larger total value of capacities, so the C-rate at the inflow side of the inrush current becomes smaller compared to the case where the current flows in the reverse direction.

The difference between the above two voltages is preferably 10 mV to 100 mV. In a case where the difference between the two voltages is less than 10 mV, there is a concern that the current may flow in the reverse direction when the voltage is unstable. In a case where the difference between the two voltages exceeds 100 mV, the magnitude of the inrush current becomes too large. It should be noted that the C-rate refers to the ratio of the charging and discharging current value to the battery capacity, and 1C represents the current value at the time of transitioning from a fully charged state to a completely discharged state in 1 hour.

With such a configuration, the composite battery system of the present invention can reduce the damage caused by the inrush current to the lithium-ion battery when the switch is turned on, thereby extending the life of the lithium-ion battery, so it is possible to effectively utilize resources.

Next, a determination criterion for deteriorated batteries applied to the composite battery system 10 of the second embodiment of the present invention will be described.

Multiple main battery portions 20 are configured with main battery portions of a basic connection number set based on specifications for each of the multiple composite units 12 and main battery portions of a surplus connection number set as a surplus portion with respect to the basic connection number. For each of the multiple composite units 12, the basic connection number may be 2 or more, but 3 or more is preferable, and 4 or more is more preferable. The surplus connection number may be 1 or more, but 2 or more is preferable, and 3 or more is more preferable. The EMS 16 may recognize a lithium-ion battery as a deteriorated battery in a case where the measurement value of current during both charging and discharging deviates from a predetermined range, and may calculate each average value of measurement values obtained by simultaneously measuring the current in each state of charging and discharging of each lithium-ion battery 22 constituting each of the multiple main battery portions 20. It should be noted that the predetermined range may be 70% to 130% for both the average value of measurement values during charging and the average value of measurement values during discharging.

For example, in a case where the basic connection number is 8 and the surplus connection number is 2 for each of the multiple composite units 12, each composite unit 12 is configured by connecting in parallel: the first to eighth lithium-ion batteries 22 connected in parallel with each other based on specifications, and the ninth and tenth lithium-ion batteries 22 connected in parallel with each other as the surplus portion. In one of N composite units 12 connected in series with each other, it is assumed that the measurement values obtained by simultaneously measuring the current in each state of charging and discharging of each lithium-ion battery 22 happen to be the same values, for example, 1.2 A, 14.0 A, 10.0 A, 10.1 A, 10.2 A, 10.3 A, 10.4 A, 10.5 A, 10.6 A, and 10.7 A. In that case, the average value of the measurement values becomes 9.8 A, and the range of 70% to 130% with respect to the average value of the measurement values becomes 6.86 A to 12.74 A, so the first measurement value 1.2 A and the second measurement value 14.0 A are outside this range in both states of charging and discharging.

Therefore, the first and second lithium-ion batteries are recognized and counted as deteriorated batteries. In this case, the EMS 16 turns off the switches 24 connected to the deteriorated batteries and notifies the external device 40 of information identifying the deteriorated batteries. The above is the specific processing content executed in one of the N composite units 12, and the EMS 16 executes similar processing for other composite units. In a case where the measurement values in both states of charging and discharging are less than 70% of each average value, it can be determined that the battery is completely deteriorated because the internal resistance has become too large. In a case where the measurement value exceeds 130% of each average value, it can be determined that the battery is completely deteriorated because there are signs of internal short circuit.

With such a configuration, the composite battery system of the present invention can reduce the possibility of determination errors due to measurement abnormalities compared to the case where detection of abnormal single cells is performed only during charging of the electric power storage device as in Patent Document 3, so it is possible to simplify the configuration and appropriately identify deteriorated lithium-ion batteries.

Next, another determination criterion for deteriorated batteries applied to the composite battery system 10 of the third embodiment of the present invention will be described.

Multiple main battery portions 20 are configured with main battery portions of a basic connection number set based on specifications for each of multiple composite units 12 and main battery portions of a surplus connection number set as a surplus portion with respect to the basic connection number. For each of the multiple composite units 12, the basic connection number may be 4 or more, but 5 or more is preferable, and 6 or more is more preferable. The surplus connection number may be 1 or more, but 2 or more is preferable, and 3 or more is more preferable. The EMS 16 may recognize a lithium-ion battery as a deteriorated battery in a case where the measurement value of current during at least one of charging and discharging deviates from a predetermined range, and in a case where there is a lithium-ion battery that the EMS 16 recognizes as a deteriorated battery among the multiple main battery portions 20, the EMS 16 may exclude the measurement value of the corresponding lithium-ion battery from the measurement values obtained by simultaneously measuring the current in at least one state of charging and discharging of each lithium-ion battery 22 constituting each of the multiple main battery portions 20, further exclude one measurement value with the maximum magnitude and one measurement value with the minimum magnitude from the remaining measurement values, and calculate an average value of the remaining measurement values. It should be noted that the predetermined range may be 70% to 130% for both the average value of measurement values during charging and the average value of measurement values during discharging.

For example, in a case where the basic connection number is 8 and the surplus connection number is 2 for each of the multiple composite units 12, each composite unit 12 is configured by connecting in parallel: the first to eighth lithium-ion batteries 22 connected in parallel with each other based on specifications, and the ninth and tenth lithium-ion batteries 22 connected in parallel with each other as the surplus portion. In one of N composite units 12 connected in series with each other, it is assumed that the measurement values obtained by simultaneously measuring the current in each state of charging and discharging of each lithium-ion battery 22 happen to be the same values, for example, 1.2 A, 14.0 A, 10.0 A, 10.1 A, 10.2 A, 10.3 A, 10.4 A, 10.5 A, 10.6 A, and 10.7 A, and moreover, the first lithium-ion battery with a measurement value of 1.2 A is a lithium-ion battery that the EMS 16 has recognized as a deteriorated battery. In that case, first 1.2 A is excluded, then the average value of the remaining 7 measurement values after excluding 14.0 A and 10.0 A becomes 10.4 A, and the range of 70% to 130% with respect to the average value of the measurement values becomes 7.28 A to 13.52 A, so the second measurement value of 14.0 A is outside this range in both states of charging and discharging.

Therefore, the second lithium-ion battery is newly recognized and counted as a deteriorated battery. In this case, the EMS 16 turns off the switch 24 connected to the deteriorated battery and notifies the external device 40 of information identifying the deteriorated battery. The above is the specific processing content executed in one of the N composite units 12, and the EMS 16 executes similar processing for other composite units. In a case where the measurement value in at least one state of charging and discharging is less than 70% of each average value, it can be determined that the battery is completely deteriorated because the internal resistance has become too large. In a case where the measurement value exceeds 130% of each average value, it can be determined that the battery is completely deteriorated because there are signs of internal short circuit.

With such a configuration, the composite battery system of the present invention can reduce the possibility of determination errors due to measurement abnormalities compared to the case of simply calculating the average current value of single batteries connected in parallel as in Patent Document 3, so it is possible to simplify the configuration and appropriately identify deteriorated lithium-ion batteries.

Next, a replacement condition for deteriorated batteries will be described.

The EMS 16 calculates the connection number of a deteriorated battery among multiple main battery portions 20 for each of the multiple composite units 12, and in a case where the connection number of the deteriorated battery becomes equal to the surplus connection number, the EMS 16 sends a signal requesting replacement of the deteriorated battery to the external device 40.

With such a configuration, the composite battery system of the present invention can maintain safety even in a case where a lithium-ion battery has deteriorated.

Next, the configuration of the auxiliary battery portion will be described.

The auxiliary battery portion 30 may further include a current meter 34, an auxiliary switch 36, and an auxiliary BMS 38. In that case, the current meter 34 measures the current flowing through the lead-acid battery 32. The auxiliary switch 36 electrically connects or disconnects the lead-acid battery 32. The auxiliary BMS 38 turns on/off the auxiliary switch 36 based on the measurement value of the current flowing through the lead-acid battery 32, and notifies the external device 40 of the measurement value of the current flowing through the lead-acid battery 32 via the HV portion 14 and the EMS 16.

With such a configuration, the composite battery system of the present invention can maintain safety even in a case where overcurrent flows through the lead-acid battery.

Next, a modification example of the auxiliary battery portion will be described. FIG. 2 is a block diagram showing a modification example of the auxiliary battery portion constituting the composite battery system of FIG. 1. An auxiliary battery portion 30a of the present invention has the same configuration as the auxiliary battery portion 30 except for the point of having a fuse 50 instead of the current meter 34 and the auxiliary switch 36, and the point of not having the auxiliary BMS 38, so the description of the same components will be omitted.

The auxiliary battery portion 30 may further have a fuse 50. In that case, the fuse 50 interrupts the current flowing through the lead-acid battery 32 in a case where overcurrent flows through the lead-acid battery 32.

With such a configuration, the composite battery system of the present invention can maintain safety even in a case where overcurrent flows through the lead-acid battery.

Next, the functions of the BMS will be described.

Each of the multiple main battery portions 20 may include a BMS 26. In that case, the BMS 26 measures the voltage, current, and temperature of the lithium-ion battery 22, calculates SOC and SOH based on the voltage, current, and temperature, and notifies the external device 40 of the measurement values of the voltage, current, and temperature and the calculated values of the SOC and SOH via the HV portion 14 and the EMS 16.

With such a configuration, the composite battery system of the present invention can use the BMS attached to the lithium-ion battery as it is, so resources can be effectively utilized.

Next, a case where the functions of the BMS are incorporated into the HV portion will be described.

The HV portion 14 may measure the voltage, current, and temperature of the lithium-ion battery 22, calculate SOC and SOH based on the voltage, current, and temperature, and notify the external device 40 of the measurement values of the voltage, current, and temperature and the calculated values of the SOC and SOH via the EMS 16.

With such a configuration, the composite battery system of the present invention integrates the functions of the BMS into the HV portion, so the configuration of the composite battery system can be simplified.

Next, temperature control inside the housing will be described.

The composite battery system 10 may further have a thermometer 52 and a heating and cooling device 54. In that case, the thermometer 52 measures the temperature inside the housing 18. The heating and cooling device 54 changes the temperature inside the housing 18. The EMS 16 turns on/off at least one of the heating and cooling device 54 and the switch 24 based on the temperature of the lithium-ion battery 22 and the measurement value of the thermometer 52, and notifies the external device 40 of the temperature of the lithium-ion battery 22 and the measurement value of the thermometer 52.

With such a configuration, the composite battery system of the present invention controls the temperature of the lithium-ion battery and the temperature inside the housing within a safe range, so safety can be maintained.

Next, fire prevention measures inside the housing will be described.

The composite battery system 10 may further have a fire extinguisher 56. In that case, the fire extinguisher 56 automatically detects and extinguishes flames that occur inside the housing 18. The EMS 16 notifies the external device 40 of operation of the fire extinguisher 56 in a case where the fire extinguisher 56 operates.

With such a configuration, the composite battery system of the present invention can maintain safety even if a fire occurs inside the housing due to lightning strike or short circuit in the wiring.

Next, hydrogen gas prevention measures inside the housing will be described.

The composite battery system 10 may further have a hydrogen gas sensor 58 and a fan 60, and the auxiliary battery portion 30 may further include an auxiliary switch 36. In that case, the hydrogen gas sensor 58 measures the concentration of hydrogen gas inside the housing 18. The fan 60 ventilates the air inside the housing 18. The auxiliary switch 36 electrically connects or disconnects the lead-acid battery 32. The EMS 16 turns on/off at least one of the fan 60 and the switch 24 based on the measurement value of the concentration of hydrogen gas, and notifies the external device 40 of the measurement value of the concentration of hydrogen gas.

With such a configuration, the composite battery system of the present invention can maintain safety even if a large amount of hydrogen gas is generated from the lead-acid battery due to overcharging of the lead-acid battery.

Next, organic gas prevention measures inside the housing will be described.

The composite battery system 10 may further have an organic gas sensor 62 and a fan 60. In that case, the organic gas sensor 62 measures the concentration of organic gas inside the housing 18. The fan 60 ventilates the air inside the housing 18. The EMS 16 turns on/off at least one of the fan 60 and the switch 24 based on the measurement value of the concentration of organic gas, and notifies the external device 40 of the measurement value of the concentration of organic gas.

With such a configuration, the composite battery system of the present invention can maintain safety even if a large amount of electrolyte leaks from the lithium-ion battery due to deterioration of the lithium-ion battery.

Next, measures for expanding the applications or enhancing the expandability of the composite battery system of the present invention will be described.

The composite battery system 10 may further have a PCS 64. In that case, the PCS 64 is disposed inside or outside the housing 18, converts discharge power from the lithium-ion battery 22 and the lead-acid battery 32 to the external device 40 from direct current to alternating current, and converts charging power from the external device 40 to the lithium-ion battery 22 and the lead-acid battery 32 from alternating current to direct current.

With such a configuration, the composite battery system of the present invention can expand the applications of the composite battery system.

The EMS 16 may turn on/off the switch 24 based on the measurement value of the voltage and notify the external device 40 of the measurement value of the voltage. In addition, the EMS 16 may receive a notification from the HV portions 14 stored respectively in multiple housings 18.

With such a configuration, the composite battery system of the present invention can enhance the expandability of the composite battery system.

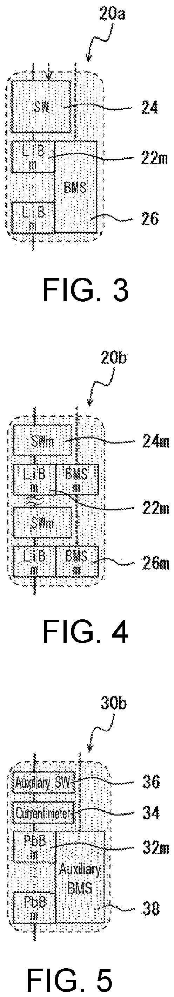

Next, specific module configurations of the main battery portion and the auxiliary battery portion will be described. FIG. 3 is a block diagram showing a specific module configuration of the main battery portion constituting the composite battery system of FIG. 1. A main battery portion 20a of the present invention has the same configuration as the main battery portion 20 except for the point of having multiple lithium-ion battery modules 22m connected in series with each other instead of the lithium-ion battery 22, so the description of the same components will be omitted. FIG. 4 is a block diagram showing another specific module configuration of the main battery portion of FIG. 3. A main battery portion 20b of the present invention has multiple lithium-ion battery modules 22m connected in series with each other instead of the lithium-ion battery 22, has switch modules 24m corresponding to the lithium-ion battery modules 22m instead of the switch 24, and has BMS modules 26m corresponding to the lithium-ion battery modules 22m instead of the BMS 26.

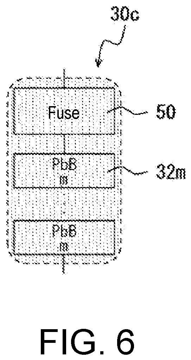

Also, FIG. 5 is a block diagram showing a specific module configuration of the auxiliary battery portion constituting the composite battery system of FIG. 1. An auxiliary battery portion 30b of the present invention has the same configuration as the auxiliary battery portion 30 except for the point of having multiple lead-acid battery modules 32m connected in series with each other instead of the lead-acid battery 32, so the description of the same components will be omitted. FIG. 6 is a block diagram showing a specific module configuration of the modification example of the auxiliary battery portion of FIG. 2. An auxiliary battery portion 30c of the present invention has the same configuration as the auxiliary battery portion 30a except for the point of having multiple lead-acid battery modules 32m connected in series with each other instead of the lead-acid battery 32, so the description of the same components will be omitted.

As an example, the configuration of a composite battery system A will be described. In the composite battery system A, multiple composite units 12 may be 2 composite units 12 connected in series with each other. The lithium-ion battery 22 may be 17 lithium-ion battery modules 22m connected in series with each other, with a battery capacity of 5.63 kWh and an operating voltage of about 24 V. The lead-acid battery 32 may be 32 lead-acid battery modules 32m connected in series with each other, with a battery capacity of 0.36 kWh and an operating voltage of about 12.75 V.

In the composite battery system A, the lithium-ion battery modules 22m are BYD AS-OP-8S, and the lithium-ion battery 22 has a battery capacity of 95.7 kWh and an operating voltage of about 408 V. The lead-acid battery modules 32m are LCPA 33-12, and the lead-acid battery 32 has a battery capacity of 11.5 kWh and an operating voltage of about 408 V. In a case where the basic connection number of the main battery portions 20 is 2 and the surplus connection number is 1, each composite unit 12 has a battery capacity of 202.9 kWh for the basic connection number and a battery capacity of 298.6 kWh including the surplus connection number. In a case where the series connection number of the composite units 12 is 2, the entirety of the multiple composite units 12 has a battery capacity of 405.8 kWh for the basic connection number and a battery capacity of 597.2 kWh including the surplus connection number, and an operating voltage of about 816 V.

As another example, the configuration of a composite battery system B will be described.

In the composite battery system B, multiple composite units 12 may be 4 composite units 12 connected in series with each other. The lithium-ion battery 22 may be 2 lithium-ion battery modules 22m connected in series with each other, with a battery capacity of 26.73 kWh and an operating voltage of about 150 V. The lead-acid battery 32 may be 24 lead-acid battery modules 32m connected in series with each other, with a battery capacity of 0.36 kWh and an operating voltage of about 12.75 V.

In the composite battery system B, the lithium-ion battery modules 22m are e-BUS battery L173TB2, and the lithium-ion battery 22 has a battery capacity of 53.46 kWh and an operating voltage of about 300 V. The lead-acid battery modules 32m are LCPA 33-12, and the lead-acid battery 32 has a battery capacity of 8.64 kWh and an operating voltage of about 306 mV. In a case where the basic connection number of the main battery portions 20 is 2 and the surplus connection number is 1, each composite unit 12 has a battery capacity of 115.6 kWh for the basic connection number and a battery capacity of 169.0 kWh including the surplus connection number. In a case where the series connection number of the composite units 12 is 4, the entirety of the multiple composite units 12 has a battery capacity of 462.2 kWh for the basic connection number and a battery capacity of 676.1 kWh including the surplus connection number, and an operating voltage of about 1200 V.

In the composite battery systems A and B, a Battery Management Unit (hereinafter referred to as BMU) is mounted inside the lithium-ion battery module 22m, and a control 12 V power supply is connected if needed to drive the BMU. In that case, the startup procedure for the composite battery systems A and B is as follows: first, the BMS software is modified in advance so that the lithium-ion battery module 22m is in a chargeable and dischargeable state even when a voltage is applied from the outside; next, a switch connected between the lithium-ion battery module 22m and the control 12 V power supply is turned on; and then, the contactor of the lithium-ion battery module 22m is turned on to enable the lithium-ion battery module 22m to be charged and discharged.

The composite battery system of the present invention is basically configured as described above.

While the composite battery system of the present invention has been described in detail above, the present invention is not limited to the above description, and it is of course possible to make various improvements or modifications within a range that does not deviate from the spirit of the present invention.

### Industrial Applicability

In addition to the effects of being capable of simplifying the configuration while ensuring the electric power storage capacity according to specifications, and identifying a deteriorated lithium-ion battery and replacing only the identified battery, the composite battery system of the present invention also has the effects of maintaining safety at a level equal to or higher than conventional systems, effectively utilizing resources, expanding applications, and enhancing expandability, and is therefore industrially useful. Description of Reference Numerals

10 composite battery system
12 composite unit
14 HV portion
16 EMS
18 housing
20, 20a, 20b main battery portion
22 lithium-ion battery
22m lithium-ion battery module
24 switch
24m switch module
26 BMS
26m BMS module
30, 30a, 30b, 30c auxiliary battery portion
32 lead-acid battery
32m lead-acid battery module
34 current meter
36 auxiliary switch
38 auxiliary BMS
40 external device
50 fuse
52 thermometer
54 heating and cooling device
56 fire extinguisher
58 hydrogen gas sensor
60 fan
62 organic gas sensor
64 PCS

## Claims

1. A composite battery system, comprising:
a plurality of composite units each comprising a plurality of main battery portions each of which comprises a lithium-ion battery and a switch that electrically connects or disconnects the lithium-ion battery and which are connected in parallel with each other, and an auxiliary battery portion which comprises a lead-acid battery and is connected in parallel with the plurality of main battery portions, the plurality of composite units being connected in series with each other;
an HV portion directly or indirectly acquiring measurement values of voltage, current, and temperature during charging and discharging of the lithium-ion battery;
an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and
a housing storing the plurality of composite units and the HV portion,
wherein the EMS recognizes the lithium-ion battery as the deteriorated battery in a case where the measurement value of current during at least one of charging and discharging deviates from a predetermined range, and
wherein in at least one composite unit of the plurality of composite units, in a case where the lithium-ion batteries constituting the plurality of main battery portions comprise one or more conducting batteries connected to the switches in an on state and one or more non-conducting batteries connected to the switches in an off state, the EMS compares a total value of capacities of the conducting batteries with a total value of capacities of the non-conducting batteries, and turns on the switches in the off state of the non-conducting batteries when a voltage of batteries with a smaller total value of capacities is higher than a voltage of batteries with a larger total value of capacities.

2. A composite battery system, comprising:
a plurality of composite units each comprising a plurality of main battery portions each of which comprises a lithium-ion battery and a switch that electrically connects or disconnects the lithium-ion battery and which are connected in parallel with each other, and an auxiliary battery portion which comprises a lead-acid battery and is connected in parallel with the plurality of main battery portions, the plurality of composite units being connected in series with each other;
an HV portion directly or indirectly acquiring measurement values of voltage, current, and temperature during charging and discharging of the lithium-ion battery;
an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and
a housing storing the plurality of composite units and the HV portion,
wherein the plurality of main battery portions comprise main battery portions of a basic connection number set based on specifications for each of the plurality of composite units, and main battery portions of a surplus connection number set as a surplus portion with respect to the basic connection number,
wherein for each of the plurality of composite units, the basic connection number is 2 or more, and the surplus connection number is 1 or more, and
wherein the EMS recognizes a lithium-ion battery as a deteriorated battery in a case where the measurement value of current during both charging and discharging deviates from a predetermined range, and calculates each average value of measurement values obtained by simultaneously measuring current in each state of charging and discharging of each lithium-ion battery constituting each of the plurality of main battery portions.

3. A composite battery system, comprising:
a plurality of composite units each comprising a plurality of main battery portions each of which comprises a lithium-ion battery and a switch that electrically connects or disconnects the lithium-ion battery and which are connected in parallel with each other, and an auxiliary battery portion which comprises a lead-acid battery and is connected in parallel with the plurality of main battery portions, the plurality of composite units being connected in series with each other;
an HV portion directly or indirectly acquiring measurement values of voltage, current, and temperature during charging and discharging of the lithium-ion battery;
an EMS, in a case of recognizing a lithium-ion battery that has deteriorated due to repeated charging and discharging of the plurality of main battery portions as a deteriorated battery, turning off the switch connected to the deteriorated battery and notifying an external device of information identifying the deteriorated battery; and
a housing storing the plurality of composite units and the HV portion,
wherein the plurality of main battery portions comprise main battery portions of a basic connection number set based on specifications for each of the plurality of composite units, and main battery portions of a surplus connection number set as a surplus portion with respect to the basic connection number,
wherein for each of the plurality of composite units, the basic connection number is 4 or more, and the surplus connection number is 1 or more, and
wherein the EMS recognizes a lithium-ion battery as a deteriorated battery in a case where the measurement value of current during at least one of charging and discharging deviates from a predetermined range, and in a case where there is a lithium-ion battery that the EMS recognizes as the deteriorated battery among the plurality of main battery portions, the EMS excludes the measurement value of the lithium-ion battery from measurement values obtained by simultaneously measuring current in each state of charging and discharging of each lithium-ion battery constituting each of the plurality of main battery portions, further excludes one measurement value with a maximum magnitude and one measurement value with a minimum magnitude from remaining measurement values, and calculates each average value of remaining measurement values.

4. The composite battery system according to claim 2 or 3, wherein the EMS calculates a connection number of the deteriorated battery among the plurality of main battery portions for each of the plurality of composite units, and in a case where the connection number of the deteriorated battery becomes equal to the surplus connection number, the EMS sends a signal requesting replacement of the deteriorated battery to the external device.

5. The composite battery system according to any one of claims 1 to 3, wherein the auxiliary battery portion further comprises:
a current meter that measures current flowing through the lead-acid battery;
an auxiliary switch that electrically connects or disconnects the lead-acid battery; and
an auxiliary BMS,
wherein the auxiliary BMS turns on/off the auxiliary switch based on the measurement value of current flowing through the lead-acid battery, and notifies the external device of the measurement value of current flowing through the lead-acid battery via the HV portion and the EMS.

6. The composite battery system according to any one of claims 1 to 3, wherein the auxiliary battery portion further comprises a fuse that interrupts current flowing through the lead-acid battery in a case where overcurrent flows through the lead-acid battery.

7. The composite battery system according to any one of claims 1 to 3, wherein each of the plurality of main battery portions comprises a BMS, and
the BMS measures the voltage, current, and temperature of the lithium-ion battery, calculates SOC and SOH based on the voltage, current, and temperature, and notifies the external device of measurement values of the voltage, current, and temperature and calculated values of the SOC and SOH via the HV portion and the EMS.

8. The composite battery system according to any one of claims 1 to 3, wherein the HV portion measures the voltage, current, and temperature of the lithium-ion battery, calculates SOC and SOH based on the voltage, current, and temperature, and notifies the external device of measurement values of the voltage, current, and temperature and calculated values of the SOC and SOH via the EMS.

9. The composite battery system according to any one of claims 1 to 3, further comprising:
a thermometer that measures a temperature inside the housing; and
a heating and cooling device that changes the temperature inside the housing,
wherein the EMS turns on/off at least one of the heating and cooling device and the switch based on a temperature of the lithium-ion battery and a measurement value of the thermometer, and notifies the external device of the temperature of the lithium-ion battery and the measurement value of the thermometer.

10. The composite battery system according to any one of claims 1 to 3, further comprising a fire extinguisher that automatically detects and extinguishes flames generated inside the housing,
wherein the EMS notifies the external device of operation of the fire extinguisher in a case where the fire extinguisher operates.

11. The composite battery system according to any one of claims 1 to 3, further comprising:
a hydrogen gas sensor that measures a concentration of hydrogen gas inside the housing; and
a fan that ventilates air inside the housing,
wherein the auxiliary battery portion further comprises an auxiliary switch that electrically connects or disconnects the lead-acid battery, and
wherein the EMS turns on/off at least one of the fan and the auxiliary switch based on a measurement value of the concentration of hydrogen gas, and notifies the external device of the measurement value of the concentration of hydrogen gas.

12. The composite battery system according to any one of claims 1 to 3, further comprising:
an organic gas sensor that measures a concentration of organic gas inside the housing; and
a fan that ventilates air inside the housing,
wherein the EMS turns on/off at least one of the fan and the switch based on a measurement value of the concentration of organic gas, and notifies the external device of the measurement value of the concentration of organic gas.

13. The composite battery system according to any one of claims 1 to 3, further comprising a PCS that is disposed inside or outside the housing, converts discharge power from the lithium-ion battery and the lead-acid battery to the external device from direct current to alternating current, and converts charging power from the external device to the lithium-ion battery and the lead-acid battery from alternating current to direct current.

14. The composite battery system according to any one of claims 1 to 3, wherein the EMS turns on/off the switch based on the measurement value of voltage, and notifies the external device of the measurement value of voltage, and
the EMS receives a notification from the HV portions stored respectively in a plurality of the housings.

15. The composite battery system according to any one of claims 1 to 3, wherein the predetermined range is 70% to 130% for both an average value of measurement values during charging and an average value of measurement values during discharging.
